# EUROPÄISCHE PATENTSCHRIFT

(11) **EP 1 095 413 B1**
(45) Veröffentlichungstag und Bekanntmachung des Hinweises auf die Patenterteilung: **05.08.2009**
(21) Anmeldenummer: 99936420.1
(22) Anmeldetag: 07.06.1999
(51) Int. Cl.: H01L 51/52

(54) **HERSTELLUNG VON STRUKTURIERTEN ELEKTRODEN**
PRODUCTION OF STRUCTURED ELECTRODES
PRODUCTION D'ELECTRODES STRUCTUREES

(30) Priorität: 18.06.1998 DE 19827224
(43) Veröffentlichungstag der Anmeldung: 02.05.2001
(73) Patentinhaber: OSRAM Opto Semiconductors GmbH, 93055 Regensburg (DE)
(72) Erfinder: GÜNTHER, Ewald, Singapore 589-630 (SG)
(74) Vertreter: Epping - Hermann - Fischer
(86) Internationale Anmeldenummer: PCT/DE1999/001655
(87) Internationale Veröffentlichungsnummer: WO 1999/066568

(56) Entgegenhaltungen:
- EP-A- 0 269 219
- EP-A- 0 341 843
- EP-A- 0 732 868
- EP-A- 0 910 128
- DE-A- 4 401 590
- US-A- 5 360 698
- DATABASE NPL 1. Februar 2008 (2008-02-01), CLARIANT: "Clariant AZ 5214 E Photoresist Data Sheet" XP007903978

## Beschreibung

Die Erfindung betrifft ein Verfahren zur Herstellung strukturierter Elektroden, insbesondere von organischen elektrolumineszierenden Bauteilen mit einer strukturierten Elektrode, wie strukturierte Metallelektroden aufweisende Displays.

Dünne Schichten, insbesondere mit einer Dicke im Bereich von 1 nm bis 10 µm, finden vielfältige technologische Anwendungen, beispielsweise in der Halbleiterfertigung, der Mikroelektronik, der Sensorik und der Displaytechnologie. Für die Herstellung von Bauteilen ist dabei fast immer eine Strukturierung der Schichten erforderlich, wobei die notwendigen Strukturgrößen vom Sub-µ-Bereich bis hin zur gesamten Substratfläche reichen und die erforderliche Formenvielfalt nahezu unbegrenzt ist.

Für die Strukturierung werden im allgemeinen die in vielen Varianten verfügbaren lithographischen Prozesse eingesetzt. Dabei ist allen Verfahren gemeinsam, daß die zu strukturierenden Schichten mit mehr oder weniger aggressiven Chemikalien in Kontakt kommen, wie Photolacke, Lösemittel, Entwicklerflüssigkeiten und Ätzgase. Bei einigen Anwendungen führen derartige Kontakte aber zur Zerstörung oder zumindest Schädigung der zu strukturierenden Schichten. Dies gilt beispielsweise für organische Leuchtdioden.

Organische Leuchtdioden (Organic Light Emitting Diodes, OLEDs), d.h. elektrolumineszierende Dioden, finden vor allem in Displays Verwendung (siehe dazu beispielsweise US-PS 4 356 429 und US-PS 5 247 190). Der Aufbau und die Herstellung von OLED-Displays erfolgen typischerweise folgendermaßen.

Ein Substrat, beispielsweise Glas, ist ganzflächig mit einer transparenten Elektrode (Bottom-Elektrode, Anode), beispielsweise aus Indium-Zinn-Oxid (ITO), beschichtet. Zur Herstellung von Pixel-Matrix-Anzeigen muß sowohl die transparente Bottom-Elektrode als auch die Top-Elektrode (Kathode) strukturiert werden. Beide Elektroden sind dabei üblicherweise in Form von parallelen Leiterbahnen strukturiert, wobei die Leiterbahnen von Bottom-Elektrode und Top-Elektrode senkrecht zueinander verlaufen. Die Strukturierung der Bottom-Elektrode erfolgt mit einem photolithographischen Prozeß unter Einschluß naßchemischer Ätzverfahren, deren Details dem Fachmann bekannt sind. Die Auflösung, die mit diesen Verfahren erreichbar ist, wird im wesentlichen durch die photolithographischen Schritte und die Beschaffenheit der Bottom-Elektrode begrenzt. Nach dem Stand der Technik sind dabei sowohl Pixelgrößen wie auch nicht emittierende Zwischenräume zwischen den Pixeln von wenigen Mikrometern Größe realisierbar. Die Länge der streifenförmigen Leiterbahnen der Bottom-Elektrode kann bis zu vielen Zentimetern betragen. Je nach verwendeter Lithographiemaske können auch emittierende Flächen bis zu einer Größe von mehreren Quadratzentimetern erzeugt werden. Die Abfolge der einzelnen emittierenden Flächen kann regelmäßig (Pixel-Matrix-Display) oder variabel sein (Symboldarstellungen).

Auf das Substrat mit der strukturierten transparenten Bottom-Elektrode werden eine oder mehrere organische Schichten aufgebracht. Diese organischen Schichten können aus Polymeren, Oligomeren, niedermolekularen Verbindungen oder Mischungen hiervon bestehen. Zum Aufbringen von Polymeren, beispielsweise Polyanilin, Poly(p-phenylen-vinylen) und Poly(2-methoxy-5-(2'-ethyl)-hexyloxy-p-phenylen-vinylen), finden üblicherweise Prozesse aus flüssiger Phase Anwendung (Auftragen einer Lösung mittels Spin-Coating oder Rakeln), während für niedermolekulare und oligomere Verbindungen eine Gasphasenabscheidung bevorzugt wird (Aufdampfen oder "Physical Vapor Deposition", PVD). Beispiele für niedermolekulare, bevorzugt positive Ladungsträger transportierende Verbindungen sind: N,N'-Bis-(3-methylphenyl)-N,N'-bis-(phenyl)-benzidin (m-TPD), 4,4',4" -Tris-(N-3-methylphenyl-N-phenyl-amino)-triphenylamin (m-MTDATA) und 4,4',4" -Tris-(carbazol-9-yl)-triphenylamin (TCTA). Als Emitter wird beispielsweise Hydroxychinolin-Aluminium-III-Salz (Alq) verwendet, das mit geeigneten Chromophoren dotiert sein kann (Chinacridon-Derivate, aromatische Kohlenwasserstoffe u.s.w.). Gegebenenfalls können zusätzliche, die elektrooptischen Eigenschaften ebenso wie die Langzeiteigenschaften beeinflussende Schichten vorhanden sein, beispielsweise aus Kupfer-Phthalocyanin. Die gesamte Dicke der Schichtabfolge kann zwischen 10 nm und 10 µm betragen, typischerweise liegt sie im Bereich zwischen 50 und 200 nm.

Die Top-Elektrode besteht üblicherweise aus einem Metall, das im allgemeinen durch Gasphasenabscheidung aufgebracht wird (thermisches Verdampfen, Sputtern oder Elektronenstrahlverdampfung). Bevorzugt werden unedle und damit insbesondere gegenüber Wasser und Sauerstoff reaktive Metalle eingesetzt, wie Lithium, Magnesium, Aluminium und Calcium sowie Legierungen dieser Metalle untereinander oder mit anderen Metallen. Die zur Herstellung einer Pixel-Matrix-Anordnung erforderliche Strukturierung der Metallelektrode wird im allgemeinen dadurch erreicht, daß das Metall durch eine Schattenmaske hindurch aufgebracht wird, die entsprechend geformte Öffnungen aufweist.

Ein in dieser Weise hergestelltes OLED-Display kann zusätzliche, die elektrooptischen Eigenschaften beeinflussende Einrichtungen enthalten, wie UV-Filter, Polarisationsfilter, Anti-Reflex-Beschichtungen, als "Micro-Cavities" bekannte Einrichtungen sowie Farbkonversions- und Farbkorrekturfilter. Ferner ist eine hermetische Verpackung ("Packaging") vorhanden, durch das die organischen elektrolumineszierenden Displays vor Umwelteinflüssen, wie Feuchtigkeit und mechanische Belastungen, geschützt werden. Außerdem können Dünnfilmtransistoren zur Ansteuerung der einzelnen Bildelemente ("Pixel") vorhanden sein.

Für hochauflösende Displays, mit denen die Darstellung eines großen Informationsgehaltes möglich ist, ist eine feine Strukturierung der Metallelektrode in Form von Leiterbahnen erforderlich, d.h. sowohl die Breite der Leiterbahnen als auch die Zwischenräume müssen unter Einhaltung enger Toleranzen im µm-Bereich strukturierbar sein. Die Breite einer Leiterbahn kann dabei zwischen 10 µm und mehreren hundert Mikrometern liegen, bevorzugt zwischen 100 und 300 µm. Zum Erreichen eines hohen Füllfaktors (Anteil der aktiven, Licht emittierenden Fläche im Verhältnis zur Gesamtfläche der Display-Anordnung) ist es außerdem erforderlich, daß die Zwischenräume zwischen den metallischen Leiterbahnen wie auch die Zwischenräume zwischen den Leiterbahnen der transparenten Bottom-Elektrode nur wenige Mikrometer betragen. Etablierte Strukturierungstechniken können hierfür nicht verwendet werden, da die vorhandenen organischen Funktionsschichten, d.h. die elektrolumineszierenden Materialien, gegenüber den für die Feinstrukturierung erforderlichen Chemikalien nicht beständig sind.

Mittels sogenannter Schattenmasken, d.h. dünnen Blechen oder Scheiben mit entsprechend der gewünschten Struktur geformten Öffnungen, können nur Schichten strukturiert werden, die nach CVD- oder PVD-Methoden hergestellt wurden. Darüber hinaus ergibt die erzielbare Auflösung - aufgrund des endlichen Abstandes zwischen Maske und Substrat - relativ schlechte Werte, und außerdem können große Flächen - infolge einer Durchbiegung der Schattenmasken - nicht fertigungstechnisch realisiert werden.

Aus der DE-A-44 01 590 ist ein Lift-Off-Verfahren zur Herstellung von strukturierten Metallisierungen unter Verwendung von zwei separaten Fotolack-Schichten bekannt. Durch das Verfahren können relativ dicke Metallstrukturen auf Halbleiterbauelementen erzeugt werden.

Des weiteren offenbart EP-A-0 732 868 ein Verfahren zur Herstellung einer organischen elektrolumineszierenden Anzeigevorrichtung. Dazu werden auf einer Vielzahl von ersten Anzeigeelektroden elektrisch isolierende Überhangstrukturen erzeugt, die aus einer ersten Schicht, beispielsweise aus Polyimid, und einer zweiten Schicht, beispielsweise aus SiO₂, aufgebaut sind. Anschließend werden unter Verwendung von Schattenmasken in den Gebieten zwischen den elektrisch isolierenden Strukturen organische Funktionsschichten für verschiedene Farbkomponenten oder auch eine einzige Farbkomponente aufgebracht, und darauffolgend wird das Material für die zweiten Anzeigeelektroden auf den organischen Funktionsschichten und den elektrisch isolierenden Strukturen abgeschieden.

Die Druckschrift US 5,360,698 offenbart einen lithographischen Strukturierungsprozess für ein Liftoff-Verfahren mit einer ersten Photolackschicht, die im tiefen Ultraviolett strukturierbar ist und einer zweiten Photolackschicht, die im tiefen Ultraviolett vernetzbar und strahlungsundurchlässig ist und bei einer anderen Wellenlänge strukturierbar ist. Bei dem Strukturierungsprozess wird zunächst die zweite Photolackschicht strukturiert und dient als Maske für die Belichtung der ersten Photolackschicht.

Aufgabe der Erfindung ist es, eine allgemein anwendbare Strukturierungstechnik für Elektroden bereitzustellen, d.h. eine Technik, die möglichst wenig Beschränkungen hinsichtlich Geometrie (Strukturgrößen, Formen, Flächen) und Herstellung (CVD- und PVD-Methoden, Lösemittelprozesse) unterliegt. Vor allem soll ein Verfahren angegeben werden, das die fertigungstaugliche Herstellung von strukturierten Elektroden in organischen elektrolumineszierenden Bauteilen erlaubt, und zwar insbesondere von feinstrukturierten metallischen Top-Elektroden für hochauflösende Displays, wobei die zu strukturierenden Elektroden nicht durch Chemikalien geschädigt werden.

Dies wird erfindungsgemäß dadurch erreicht,
- dass auf eine auf einem Substrat (1) befindliche Bottom-Elektrode (2) mindestens zwei Schichten (3, 4) aus einem organischen filmbildenden Material aufgebracht werden, wobei die erste Schicht (3) und die zweite Schicht (4) in unterschiedlichen Lösemitteln löslich sind,
- dass die erste Schicht (3) elektrisch isolierend ist, aus einem positiven Photolack besteht und beim Aufbringen der zweiten Schicht (4) nicht geschädigt wird und zwischen den beiden Schichten eine definierte Grenze erhalten bleibt,
- dass die erste Schicht eine höhere Löslichkeitsrate in einem flüssigen Entwickler aufweist als die zweite Schicht und die zweite Schicht vernetzbar und lichtempfindlich ist, so dass sie durch Belichten und Entwickeln strukturierbar ist, und aus einem positiven oder negativen Photolack besteht,
- dass die erste Schicht vor dem Aufbringen der zweiten Schicht flutbelichtet wird,
- dass die zweite Schicht strukturiert und die Struktur in die erste Schicht übertragen wird, wobei die zweite Schicht belichtet wird und ein Strukturieren der ersten und zweiten Schicht erfolgt, das ein Entwickeln der ersten und zweiten Schicht in dem flüssigen Entwickler umfasst, und dann die zweite Schicht vernetzt wird oder die zweite Schicht zuerst mittels des Belichtungsschrittes und Entwickeln strukturiert wird und vernetzt wird und dann die Struktur durch Entwickeln in die erste Schicht übertragen wird,
wobei die zweite Schicht eine größere Strukturbreite aufweist als die erste Schicht und der Unterschied in der Strukturbreite der beiden Schichten bei der Vernetzung erhalten bleibt,
- dass auf die zweite Schicht (4) wenigstens eine organische Funktionsschicht (5) aufgebracht wird,
- und dass über der zweiten Schicht und auf der organischen Funktionsschicht die Elektrode (6) abgeschieden wird.

Die Erfindung betrifft außerdern ein organisches lichtemittierendes Bauteil mit einem Substrat (1), einer ersten Schicht (3), die auf dem Substrat (1) aufgebracht ist, einer zweiten Schicht (4), die so auf der ersten Schicht (3) ausgebildet ist, dass zwischen den beiden Schichten eine definierte Grenze besteht, und die eine größere Strukturbreite aufweist als die erste Schicht, und einer Elektrode (6), die über der zweiten Schicht (4) abgeschieden ist,
dadurch gekennzeichnet,
- dass die zwei Schichten (3, 4) auf eine auf dem Substrat befindliche Bottom-Elektrode (2) aufgebracht sind und auf die zweite Schicht (4) wenigstens eine organische Funktionsschicht (5) aufgebracht ist, und auf der organischen Funktionsschicht die Elektrode (6) abgeschieden ist,
- dass die erste Schicht (3) und die zweite Schicht (4) in unterschiedlichen Lösemitteln löslich sind,
- dass die erste Schicht (3) elektrisch isolierend ist, aus einem aus einem organischen filmbildenden Material besteht, welches ein belichteter positiver Photolack ist, und
- dass die zweite Schicht (4) aus einem organischen filmbildenden Material besteht, welches ein positiver oder negativer Photolack ist, und vernetzt ist.

Durch die Erfindung wird ein neuartiges Verfahren zur maskenlosen Herstellung von strukturierten Elektroden, insbesondere für organische elektrolumineszierende Bauteile, geschaffen. Dieses Verfahren ermöglicht vor allem die Herstellung von strukturierten Metallelektroden, insbesondere für organische elektrolumineszierende Displays. Mittels dieses Verfahrens können Strukturen erzeugt werden, die für großflächige Displays geeignet sind, und außerdem ist damit die Strukturierung von Metallelektroden auf elektrolumineszierenden Polymeren möglich. Das Verfahren nach der Erfindung eignet sich insbesondere auch für solche Anwendungsfälle, bei denen das an sich fertigungstaugliche lithographische Verfahren entsprechend der deutschen Patentanmeldung Akt.Z. 197 45 610.3 ("Herstellung von organischen elektrolumineszierenden Bauteilen") nicht ausreichend ist.

Beim Verfahren nach der Erfindung werden die zwei Schichten vorzugsweise auf eine auf dem Substrat befindliche Bottom-Elektrode aufgebracht. Auf die zweite Schicht wird dann - nach Strukturierung, Strukturübertragung und Vernetzung - zunächst wenigstens eine organische Funktionsschicht aufgebracht, und anschließend wird auf der organischen Funktionsschicht eine Top-Elektrode abgeschieden.

Die Top-Elektrode, die vorzugsweise eine kleine Austrittsarbeit für Elektronen aufweist und damit als elektroneninjizierende Elektrode fungiert, besteht insbesondere aus Metall oder einer metallischen Legierung. Diese Elektrode kann jedoch auch einen Schichtaufbau aufweisen, wobei auf einer dünnen dielektrischen Schicht (< 5 nm), die beispielsweise aus Lithiumfluorid oder Aluminiumoxid besteht, eine Metall- oder ITO-Schicht als (transparente) Elektrode angeordnet ist.

Beim Verfahren nach der Erfindung ist wesentlich, daß die erste auf die Bottom-Elektrode, die strukturiert sein kann, aufgebrachte Schicht, d.h. die untere Schicht, beim Aufbringen der zweiten Schicht (obere Schicht) nicht geschädigt wird und zwischen den beiden Schichten eine definierte Grenze erhalten bleibt. Die erste und die zweite Schicht bestehen vorteilhaft aus einem organischen filmbildenden Material, welches ein Photolack ist.

Photolacke, die auch als Photoresists bezeichnet werden, sind lichtempfindliche, filmbildende Materialien, deren Löslichkeitsverhalten sich durch Belichtung oder durch Bestrahlung ändert; dabei wird zwischen positiven und negativen Photolacken unterschieden. Besteht im vorliegenden Fall sowohl die obere als auch die untere Schicht aus einem Photolack und sind beide Photolacke im gleichen Wellenlängenbereich empfindlich, dann darf der Photolack der unteren Schicht kein negativ arbeitendes System sein.

Das Verfahren beinhaltet als wesentliches Merkmal einen photolithographischen Prozeß, bei dem auf die transparente Bottom-Elektrode, gegebenenfalls nach deren Strukturierung, wenigstens zwei Schichten aufgebracht werden, von denen die erste Schicht aus einem positiven Photolack und die zweite Schicht aus einem positiven oder negativen Photolack besteht; die erste Schicht aus Photolack wird vor dem Aufbringen der zweiten Schicht flutbelichtet. Die Schichten werden dann derart strukturiert, daß die organischen Funktionsschichten und die (metallische) Top-Elektrode darauf flächig aufgebracht bzw. abgeschieden werden können. Die Strukturierung der Schichten bzw. der Top-Elektrode verläuft dabei quer zur Strukturierung der Bottom-Elektrode. Das Aufbringen der organischen Funktionsschicht(en) auf die zweite Schicht kann allgemein sowohl durch einen thermischen Verdampfungsprozeß als auch aus einer Lösung, beispielsweise durch Aufschleudern oder Rakeln und anschließende Trocknung, erfolgen.

Beim photolithographischen Verfahrensschritt ist folgendes wichtig. Die erste der beiden Schichten muß überlackfähig ("overcoatable") sein. Dies bedeutet, daß die beiden Schichten ohne ein sogenanntes Intermixing übereinander aufgebracht werden können, d.h. die eingesetzten Lacke sind in unterschiedlichen Lösemitteln löslich, so daß der (Photo)Lack der ersten Schicht durch das Lösemittel für den Photolack der zweiten Schicht nicht angegriffen wird. Dadurch ist gewährleistet, daß der definierte Aufbau der ersten Schicht beim Aufbringen der zweiten Schicht erhalten bleibt und zwischen den beiden Schichten eine definierte Grenze existiert.

Für den photolithographischen Verfahrensschritt ist außerdem erforderlich, daß die erste Schicht eine höhere Entwicklungsrate aufweist als die zweite Schicht. Dies bedeutet, daß bei der - nach der Belichtung - für die Strukturierung erforderlichen Behandlung der Lackschichten mit einer Entwicklerlösung sich die erste Schicht schneller auflöst als die zweite Schicht. Von Vorteil ist es dabei, wenn die beiden Schichten mit demselben Entwickler, der insbesondere ein wäßrig-alkalischer Entwickler ist, behandelt, d.h. entwickelt werden können.

Vorzugsweise besteht die untere Schicht aus einem positiven Photoresist auf der Basis von Polyglutarimid oder Polybenzoxazol.

Die obere Schicht ist vorteilhaft ebenfalls ein Photolack. Vorzugsweise besteht diese Schicht aus einem positiven Photoresist (Positivresist) auf Novolak/Diazochinon-Basis oder aus einem negativen Photoresist (Negativresist) auf der Basis Növolak/Vernetzer/Photosäure. Als Positivresist kann auch Poly(methylmethacrylat) (PMMA) eingesetzt werden, und als Negativresist können beispielsweise auch vernetzbare Poly-(silphenylen-siloxane) dienen.

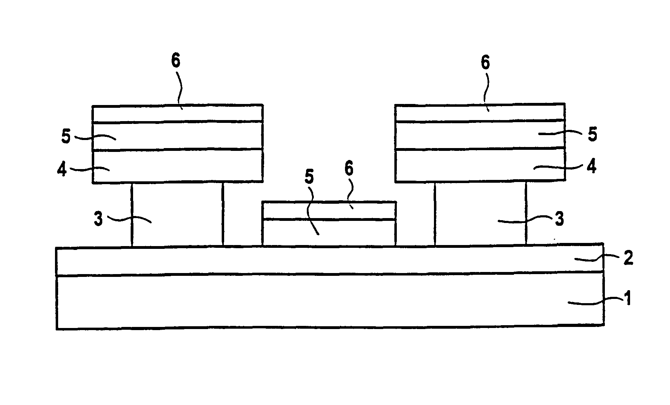

Durch eine Prozeßführung der vorstehend genannten Art ergibt sich eine in der Figur dargestellte Struktur, wobei die zweite Schicht eine größere Strukturbreite aufweist als die erste Schicht ("Überhangstruktur"). Die zweite Schicht, die aus einem filmbildenden organischen Material besteht, ist vernetzt, wodurch die mechanische Stabilität und die thermische Beständigkeit erhöht wird. Die Überhangstruktur wird durch die Vernetzung nicht beeinträchtigt.

Aufgrund der Vernetzung wird der Überhang der zweiten Schicht stabilisiert, so daß größere Flächen, insbesondere lange Kanten, realisiert werden können und die Schichterzeugung mittels Lösemittelprozessen erfolgen kann. Der stabile Überhang bewirkt dann die Strukturierung der nachfolgend aufgebrachten Schichten, weil an der Kante des Überhangs sowohl durch CVD- oder PVD-Prozesse als auch aus flüssiger Phase aufgebrachte Schichten abreißen und somit in verschiedene Zonen separiert, d.h. strukturiert werden. Dies sind insbesondere organische Funktionsschichten, d.h. elektrolumineszierende Schichten, und Elektroden.

Die obere Schicht weist, wie bereits ausgeführt, nach der Strukturierung eine größere Strukturbreite auf als die untere Schicht. Der Unterschied in der Strukturbreite ("Überhang") beträgt dabei vorteilhaft zwischen 0,1 und 50 µm, insbesondere zwischen 1 und 10 µm. Vorzugsweise beträgt die Dicke der unteren Schicht 0,1 bis 30 µm, insbesondere 0,5 bis 10 µm, und diejenige der oberen Schicht 0,1 bis 30 µm, insbesondere 0,5 bis 5 µm.

Anhand von Ausführungsbeispielen und einer Figur soll die Erfindung noch näher erläutert werden.

Die Figur zeigt - nicht maßstäblich - einen schematischen Querschnitt durch eine nach dem erfindungsgemäßen Verfahren hergestellte organische Leuchtdiode. Dabei befindet sich auf einem Substrat 1 eine transparente strukturierte Bottom-Elektrode 2. Das Substrat, das eine nicht-planare Geometrie aufweisen kann, besteht beispielsweise aus Glas, Metall, wie Silicium, oder aus einem Polymer (in Form einer Folie); die Bottom-Elektrode ist beispielsweise eine ITO-Elektrode (ITO = Indium Tin Oxide). Die nachfolgenden Schichten sind eine untere Photolackschicht 3, eine obere Photolackschicht 4, die vernetzt ist, und eine organische Funktionsschicht 5. Auf der organischen Funktionsschicht 5 befindet sich dann die strukturierte Top-Elektrode 6 (Metallelektrode).

### Beispiel 1

### Herstellung eines OLED-Displays

Die Herstellung des Displays verläuft nach folgenden Prozeßschritten:
1. Eine ganzflächig mit Indium-Zinn-Oxid (ITO) beschichtete Glasplatte wird mit Hilfe eines photolithographischen Verfahrens mit anschließendem naßchemischen Ätzen derart strukturiert, daß parallele Leiterbahnen mit einer Breite von ca. 200 µm und einem Zwischenraum von ca. 50 µm entstehen. Die Leiterbahnen sind jeweils etwa 2 cm lang und enthalten an ihrem äußeren Ende gegebenenfalls Zusätze zur Kontaktierung. Der bei der Strukturierung verwendete Photolack wird vollständig entfernt.
2. Die Glasplatte wird ca. 1 h bei einer Temperatur von 250°C ausgeheizt, dann wird ein kommerzieller Photolack auf der Basis von Polyglutarimid aufgeschleudert (Aufbringen während 10 s bei 700 U/min, Abschleudern für 30 s bei 3000 U/min). Die erhaltene Schicht wird 15 min bei 150°C und dann 30 min bei 250°C in einem Umluftofen getrocknet. Anschließend erfolgt eine Flutbelichtung bei einer Wellenlänge von 248 nm (polychromatisch) mit einer Dosis von 1000 mJ/cm². Danach wird ein kommerzieller Photolack auf der Basis von Novolak/Diazochinon (10:1 mit (1-Methoxy-2-propyl)-acetat verdünnt) bei 2000 U/min während 20 s aufgeschleudert. Die beiden Schichten werden 60 s bei 100°C getrocknet, und anschließend wird mit einer Dosis von 62 mJ/cm² bei einer Wellenlänge von 365 nm (polychromatisch) durch eine Lithographiemaske belichtet. Dann wird mit einem Tetramethylammoniumhydroxyd enthaltenden kommerziellen Entwickler 20 s entwickelt. Nachfolgend wird die Glasplatte in einen auf 100°C vorgeheizten Umluftofen gegeben und dann wird 45 min bei 230°C getempert; dabei vernetzt die obere Photolackschicht. Danach wird mit dem beschriebenen Entwickler noch zweimal für je 70 s entwickelt; dabei entsteht ein Überhang der oberen Schicht von ca. 5 µm. Die Schichtdicke der unteren Schicht beträgt etwa 2,6 µm; beide Schichten zusammen sind etwa 4,3 µm dick. Anschließend werden mittels eines Sauerstoffplasmas (RF-Leistung: 70 W, Gasfluß: 30 sccm) für 90 s Lackreste von der ITO-Oberfläche entfernt.
3. Bei einem Druck von 10⁻⁵mbar wird durch konventionelles thermisches Aufdampfen eine Schicht aus N,N'-Bis(3-methylphenyl)-N,N'-bis(phenyl)-benzidin (m-TPD) aufgebracht (Schichtdicke: 135 nm, Aufdampfrate: 0,2 nm/s). Ohne Änderung des Druckes, d.h. ohne Belüften des Vakuum-Rezipienten, wird anschließend durch thermisches Verdampfen eine Schicht aus Hydroxychinolin-Aluminium(III)-Salz (Alq) mit einer Dicke von 65 nm aufgebracht (Aufdampfrate: 0,2 nm/s).
4. Ohne Verwendung einer Maske wird durch thermisches Verdampfen Magnesium in einer Schichtdicke von 100 nm auf die aktive Fläche des Displays aufgebracht (Depositionsrate: 1 nm/s, Druck: 10⁻⁵ mbar). Ohne das Vakuum zu unterbrechen, wird - ebenfalls durch thermisches Verdampfen - Silber in einer Schichtdicke von 100 nm auf die aktive Display-Fläche aufgebracht (Depositionsrate: 1 nm/s, Druck: 10⁻⁵ mbar).

Das Display leuchtet deutlich sichtbar, auch bei hellem Tageslicht unter Sonneneinstrahlung; die Emissionsfarbe ist grünlich-gelb.

### Beispiel 2

Herstellung eines OLED-Displays

Auf eine Glasplatte mit einem entsprechend Beispiel 1 hergestellten Schichtaufbau wird eine 1 %ige Lösung eines elektrolumineszierenden Polymers auf Fluorenbasis in Xylol aufgeschleudert (4000 U/min, 30 s). Anschließend wird 60 s bei 85°C getrocknet. Ohne Verwendung einer Maske wird dann durch thermisches Verdampfen Calcium in einer Schichtdicke von 100 nm auf die aktive Fläche des Displays aufgebracht (Depositionsrate: 1 nm/s, Druck: 10⁻⁵ mbar). Ohne das Vakuum zu unterbrechen, wird anschließend - ebenfalls durch thermisches Verdampfen - Silber in einer Schichtdicke von 100 nm auf die aktive Display-Fläche aufgebracht (Depositionsrate: 1 nm/s, Druck: 10⁻⁵ mbar).

Das Display leuchtet deutlich sichtbar, auch bei hellem Tageslicht unter Sonneneinstrahlung; die Emissionsfarbe ist grünlich-gelb.

## Patentansprüche

1. Verfahren zur Herstellung eines organischen elektrolumineszierenden Bauteils mit einer strukturierten Elektrode (6),
**dadurch gekennzeichnet,**
- **dass** auf eine auf einem Substrat (1) befindliche Bottom-Elektrode (2) mindestens zwei Schichten (3, 4) aus einem organischen filmbildenden Material aufgebracht werden, wobei die erste Schicht (3) und die zweite Schicht (4) in unterschiedlichen Lösemitteln löslich sind,
- **dass** die erste Schicht (3) elektrisch isolierend ist, aus einem positiven Photolack besteht und beim Aufbringen der zweiten Schicht (4) nicht geschädigt wird und zwischen den beiden Schichten eine definierte Grenze erhalten bleibt,
- **dass** die erste Schicht eine höhere Löslichkeitsrate in einem flüssigen Entwickler aufweist als die zweite Schicht und die zweite Schicht vernetzbar und lichtempfindlich ist, so dass sie durch Belichten und Entwickeln strukturierbar ist, und aus einem positiven oder negativen Photolack besteht,
- **dass** die erste Schicht vor dem Aufbringen der zweiten Schicht flutbelichtet wird,
- **daß** die zweite Schicht strukturiert und die Struktur in die erste Schicht übertragen wird, wobei die zweite Schicht belichtet wird und ein Strukturieren der ersten und zweiten Schicht erfolgt, das ein Entwickeln der ersten und zweiten Schicht in dem flüssigen Entwickler umfasst, und dann die zweite Schicht vernetzt wird
oder die zweite Schicht zuerst mittels des Belichtungsschrittes und Entwickeln strukturiert wird und vernetzt wird und dann die Struktur durch Entwickeln in die erste Schicht übertragen wird,
wobei die zweite Schicht eine größere Strukturbreite aufweist als die erste Schicht und der Unterschied in der Strukturbreite der beiden Schichten bei der Vernetzung erhalten bleibt,
- **dass** auf die zweite Schicht (4) wenigstens eine organische Funktionsschicht (5) aufgebracht wird,
- und **daß** über der zweiten Schicht und auf der organischen Funktionsschicht die Elektrode (6) abgeschieden wird.

2. Verfahren nach Anspruch 1, **dadurch gekennzeichnet , daß** die erste Schicht (3) aus einem positiven Photolack auf der Basis von Polyglutarimid oder Polybenzoxazol besteht.

3. Verfahren nach einem der Ansprüche 1 oder 2, **dadurch gekennzeichnet , daß** die zweite Schicht (4) aus einem positiven Photolack auf der Basis Novolak/Diazochinon besteht.

4. Verfahren nach einem der Ansprüche 1 oder 2, **dadurch gekennzeichnet , daß** die zweiten Schicht (4) aus einem negativen Photolack auf der Basis Novolak/Vernetzer/Photosäure besteht.

5. Verfahren nach einem der Ansprüche 1 bis 4 zur Herstellung einer strukturierten Elektrode (6) für ein organisches lichtemittierendes Bauteil, bei dem als organische Funktionsschicht (5) eine organische, elektrolumineszierende Schicht verwendet wird.

6. Verfahren nach einem der vorhergehenden Ansprüche, bei dem die erste Schicht (3) und die zweite Schicht (4) zur Entwicklung mit demselben Entwickler geeignet sind.

7. Verfahren nach einem der vorhergehenden Ansprüche, bei dem das Vernetzen der zweiten Schicht (4) durch Tempern erfolgt.

8. Organisches lichtemittierendes Bauteil mit einem Substrat (1), einer ersten Schicht (3), die auf dem Substrat (1) aufgebracht ist, einer zweiten Schicht (4), die so auf der ersten Schicht (3) ausgebildet ist, dass zwischen den beiden Schichten eine definierte Grenze besteht, und die eine größere Strukturbreite aufweist als die erste Schicht, und einer Elektrode (6), die über der zweiten Schicht (4) abgeschieden ist,
**dadurch gekennzeichnet,**
- **dass** die zwei Schichten (3, 4) auf eine auf dem Substrat befindliche Bottom-Elektrode (2) aufgebracht sind und auf die zweite Schicht (4) wenigstens eine organische Funktionsschicht (5) aufgebracht ist, und auf der organischen Funktionsschicht die Elektrode (6) abgeschieden ist,
- **dass** die erste Schicht (3) und die zweite Schicht (4) in unterschiedlichen Lösemitteln löslich sind,
- **dass** die erste Schicht (3) elektrisch isolierend ist, aus einem aus einem organischen filmbildenden Material besteht, welches ein belichteter positiver Photolack ist, und
- **dass** die zweite Schicht (4) aus einem organischen filmbildenden Material besteht, welches ein positiver oder negativer Photolack ist, und vernetzt ist.

9. Organisches lichtemittierendes Bauteil nach Anspruch 8, **dadurch gekennzeichnet , daß** die erste Schicht (3) aus einem positiven Photolack auf der Basis von Polyglutarimid oder Polybenzoxazol besteht.

10. Organisches lichtemittierendes Bauteil nach einem der Ansprüche 8 oder 9, **dadurch gekennzeichnet, daß** die zweite Schicht (4) aus einem positiven Photolack auf der Basis Novolak/Diazochinon besteht.

11. Organisches lichtemittierendes Bauteil nach einem der Ansprüche 8 oder 9, **dadurch gekennzeichnet, daß** die zweite Schicht (4) aus einem negativen Photolack auf der Basis Novolak/Vernetzer/Photosäure besteht.

12. Organisches lichtemittierendes Bauteil nach einem der Ansprüche 8 bis 11, bei dem als organische Funktionsschicht (5) eine organische, elektrolumineszierende Schicht verwendet ist.

13. Organisches lichtemittierendes Bauteil nach einem der Ansprüche 8 bis 12, bei dem die erste Schicht (3) und die zweite Schicht (4) zur Entwicklung mit demselben Entwickler geeignet sind.

## Claims

1. Method for manufacturing an organic electroluminescent component with a structured electrode (6),
**characterized in that**
- at least two layers (3, 4) made of an organic film-forming material are applied to a bottom electrode (2) located on a substrate (1), the first layer (3) and the second layer (4) being soluble in different solvents,
- the first layer (3) is electrically insulating, consists of a positive photoresist and is not damaged during the application of the second layer (4), and a defined boundary is preserved between the two layers,
- the first layer has a higher solubility rate in a liquid developer than the second layer, and the second layer can be cross-linked and is photosensitive so that it can be structured by exposure and developing, and consists of a positive or negative photoresist,
- the first layer is flood-exposed before the application of the second layer,
- the second layer is structured and the structure is transferred to the first layer, wherein the second layer is exposed and a structuring of the first and second layers taking place, which comprises a developing of the first and second layers in the liquid developer, and then the second layer is cross-linked
or wherein the second layer is first structured and cross-linked by means of the exposure step and developing and the structure is then transferred to the first layer by developing,
wherein the second layer has a larger structure width than the first layer and the difference in the structure width of the two layers is preserved during the cross-linking,
- at least one organic functional layer (5) is applied to the second layer (4),
- and the electrode (6) is deposited over the second layer and on the organic functional layer.

2. Method according to Claim 1, **characterized in that** the first layer (3) consists of a positive photoresist based on polyglutarimide or polybenzoxazole.

3. Method according to one of Claims 1 or 2, **characterized in that** the second layer (4) consists of a positive photoresist based on novolak/diazoquinone.

4. Method according to one of Claims 1 or 2, **characterized in that** the second layer (4) consists of a negative photoresist based on novolak/cross-linking agent/photoacid.

5. Method according to any one of Claims 1 to 4 for manufacturing a structured electrode (6) for an organic light-emitting component,
in which an organic, electroluminescent layer is used as an organic functional layer (5).

6. Method according to any one of the preceding claims, in which the first layer (3) and the second layer (4) are suitable for developing with the same developer.

7. Method according to any one of the preceding claims, in which the cross-linking of the second layer (4) is effected by annealing.

8. Organic light-emitting component with a substrate (1), a first layer (3) that is applied to the substrate (1), a second layer (4) that is formed on the first layer (3) in such a way that a defined boundary exists between the two layers, and that has a larger structure width than the first layer, and with an electrode (6) that is deposited over the second layer (4) ,
**characterized in that**
- the two layers (3, 4) are applied to a bottom electrode (2) located on the substrate and at least one organic functional layer (5) is applied to the second layer (4), and the electrode (6) is deposited on the organic functional layer,
- the first layer (3) and the second layer (4) are soluble in different solvents,
- the first layer (3) is electrically insulating and consists of an organic film-forming material, which is an exposed positive photoresist, and
- the second layer (4) consists of an organic film-forming material, which is a positive or negative photoresist, and is cross-linked.

9. Organic light-emitting component according to Claim 8, **characterized in that** the first layer (3) consists of a positive photoresist based on polyglutarimide or polybenzoxazole.

10. Organic light-emitting component according to one of Claims 8 or 9, **characterized in that** the second layer (4) consists of a positive photoresist based on novolak/diazoquinone.

11. Organic light-emitting component according to one of Claims 8 or 9, **characterized in that** the second layer (4) consists of a negative photoresist based on novolak/cross-linking agent/photoacid.

12. Organic light-emitting component according to any one of Claims 8 to 11, in which an organic, electroluminescent layer is used as an organic functional layer (5).

13. Organic light-emitting component according to any one of Claims 8 to 12, in which the first layer (3) and the second layer (4) are suitable for developing with the same developer.

## Revendications

1. Procédé pour la fabrication d'un composant organique électroluminescent avec une électrode structurée (6),
**caractérisé en ce que**
■ deux couches (3, 4) au moins d'une substance filmogène organique sont appliquées sur une électrode de sole (2) disposée sur un substrat (1), dont la première couche (3) et la seconde couche (4) sont solubles dans des solvants différents,
■ la première couche (3) est électriquement isolante, se compose d'une substance photorésistante positive et qu'elle n'est pas endommagée lors de l'application de la seconde couche (4) et qu'une limite définie reste maintenue entre les deux couches,
■ la première couche présente un taux de solubilité plus élevé dans un révélateur liquide que la seconde couche et que ladite seconde couche est réticulable et photosensible, si bien qu'elle est structurable par exposition et révélation et se compose d'une substance photorésistante positive ou négative,
■ la première couche est exposée uniformément avant l'application de la seconde couche,
■ la seconde couche est structurée et que la structure est transmise à la première couche, la seconde couche étant exposée et une structuration de la première et de la seconde couche étant effectuée, laquelle comprend la révélation de la première et de la seconde couche dans le révélateur liquide, et la seconde couche étant réticulée, ou que la seconde couche étant d'abord structurée et réticulée à l'aide de l'étape d'exposition et de la révélation, puis la structure étant transmise à la première couche par révélation, la seconde couche présentant une largeur de structure plus grande que celle de la première couche et la différence entre les largeurs de structure respectives des deux couches restant maintenue lors de la réticulation,
■ qu'une couche fonctionnelle organique (5) au moins est appliquée sur la seconde couche (4) et que
■ l'électrode (6) est déposée sur la seconde couche et sur la couche fonctionnelle organique.

2. Procédé selon la revendication 1, **caractérisé en ce que** la première couche (3) se compose d'une substance photorésistante positive à base de polyglutarimide ou de polybenzoxazole.

3. Procédé selon l'une quelconque des revendications 1 ou 2, **caractérisé en ce que** la seconde couche (4) se compose d'une substance photorésistante positive à base de novolaque/diazochinon.

4. Procédé selon l'une quelconque des revendications 1 ou 2, **caractérisé en ce que** la seconde couche (4) se compose d'une substance photorésistante négative à base de novolaque/agent de réticulation/photoacide.

5. Procédé selon l'une quelconque des revendications 1 à 4 pour la fabrication d'une électrode structurée (6) pour un composant organique émetteur de lumière, dans lequel une couche électroluminescente organique est utilisée comme couche fonctionnelle (5).

6. Procédé selon l'une quelconque des revendications précédentes, dans lequel la première couche (3) et la seconde couche (4) sont appropriées pour la révélation avec le même révélateur.

7. Procédé selon l'une quelconque des revendications précédentes, dans lequel la réticulation de la seconde couche (4) est effectué par étuvage.

8. Composant organique émetteur de lumière avec un substrat (1), une première couche (3) appliquée sur le substrat (1), une seconde couche (4) se présentant sur la première couche (3) sous une forme telle qu'il existe une limite définie entre les deux couches et présentant une largeur de structure plus grande que celle de la première couche (3) et une électrode (6) qui est déposée sur la seconde couche (4),
**caractérisé en ce que**
■ les deux couches (3, 4) sont appliquées sur une électrode de sole (2) disposée sur le substrat, qu'une couche fonctionnelle organique (5) au moins est appliquée sur la seconde couche (4) et que l'électrode(6) est déposée sur la couche fonctionnelle organique.
■ la première couche (3) et la seconde couche (4) sont solubles dans des solvants différents,
■ la première couche (3) est électriquement isolante, qu'elle se compose d'une substance filmogène organique, laquelle est une substance photorésistante positive exposée, et que
■ la seconde couche (4) se compose d'une substance filmogène organique, laquelle est une substance photorésistante positive ou négative et réticulée.

9. Composant organique émetteur de lumière selon la revendication 8, **caractérisé en ce que** la première couche (3) se compose d'une substance photorésistante positive à base de polyglutarimide ou de polybenzoxazole.

10. Composant organique émetteur de lumière selon l'une quelconque des revendications 8 ou 9, **caractérisé en ce que** la seconde couche (4) se compose d'une substance photorésistante positive à base de novolaque/diazochinon.

11. Composant organique émetteur de lumière selon l'une quelconque des revendications 8 ou 9, **caractérisé en ce que** la seconde couche (4) se compose d'une substance photorésistante négative à base de novolaque/agent de réticulation/photoacide.

12. Composant organique émetteur de lumière selon l'une quelconque des revendications 8 à 11, dans lequel une couche électroluminescente organique est utilisée comme couche fonctionnelle (5).

13. Composant organique émetteur de lumière selon l'une quelconque des revendications 8 à 12, dans lequel la première couche (3) et la seconde couche (4) sont appropriées pour la révélation avec le même révélateur.
